# EUROPEAN PATENT APPLICATION

(11) **EP 2 506 025 A1**
(43) Date of publication of application: **03.10.2012**
(21) Application number: 12158998.0
(22) Date of filing: 12.03.2012
(51) Int. Cl.: G01R 31/36, H02J 7/00, B60L 11/18

(54) **Battery control by update of current profile**

(30) Priority: 31.03.2011 JP 2011081121
(71) Applicant: Kabushiki Kaisha Toyota Jidoshokki, Kariya-shi, Aichi 448-8671 (JP)
(72) Inventor: Yamamoto, Munetaka, Kariya-shi, Aichi 448-8671 (JP); Kuraishi, Mamoru, Kariya-shi, Aichi 448-8671 (JP)
(74) Representative: TBK

(57) **Abstract**

A SOC acquisition unit (1) acquires a SOC of a battery. Then, it estimates a capacity profile from the acquired SOC, and transmits the estimated capacity profile to an estimation unit (2). The estimation unit (2) calculates a current profile for realizing the capacity profile estimated by the SOC acquisition unit (1). An update unit (3) replaces the existing stored current profile with the current profile calculated by the estimation unit (2). A storage unit (4) stores a current profile calculated by the estimation unit (2) and updated by the update unit (3). A charging unit (5) reads the current profile stored in the storage unit (4), and performs a charging operation based on the current profile.

## Description

### FIELD

The present invention relates to a system and a method for charging a battery using the optimum current profile.

### BACKGROUND

When a common battery is charged, for example, when a battery loaded into a vehicle is to be charged at a charging station etc., the charging operation is started by a constant current, for example. When the voltage increases with the start of the charging operation, reaches a constant voltage, and enters a state called a "full charge" state, the current is gradually decreased, which is called a current profile. The current profile is also referred to as a charging profile, and indicates the relationship between the charging time and the current.

Since the capacity of the battery is the electric charge accumulated in the battery when it is time-integrated, it is also referred to as the capacity of electric charge. Since the electric charge accumulated with the degradation of the battery decreases, the capacity profile also changes. However, the change is unknown. If the charging operation is performed using the same current profile as the profile before the degradation in the state in which the battery is degraded and the capacity profile changes, then the overcharge state is caused, thereby fast degrading the battery. Therefore, it is necessary to change the value of the charging current with the change of the capacity value, that is, to perform controlling to decrease the charging current at an earlier stage.

To estimate the change of the capacity of the battery with the progress of the degradation, various attempts have been conventionally made.

For example, the patent document 1 discloses a method for estimating the degraded state of a rechargeable battery and a discrimination device capable of realizing the method. This method includes: a process of continuously measuring the voltage of the rechargeable battery while charging the rechargeable battery by a constant current; a process of storing the continuously measured voltage as associated with a charging time; a process of calculating a ratio of a voltage change to the charging time from the data of a change with passage of time of the voltage of the rechargeable battery stored before when the continuously measured voltage of the rechargeable battery reaches a specified voltage; and a process of estimating the capacity of the full charge of the rechargeable battery from the calculated voltage change rate.

The patent document 2 discloses a lithium ion battery pack including a method of easily estimating the capacity of a lithium ion battery and a device for warning the degradation of a battery required in determining the degradation of a lithium ion battery. According to the method, when a lithium ion battery is charged by a constant current and voltage system, a charging current value It is obtained at the time after the passage of time t from the time point when the charging condition is switched from the constant current (CC) to the constant voltage (CV), and the capacity Ct of the lithium ion battery is estimated using the charging current value It.

Furthermore, the patent document 3 discloses a battery charging state estimating method, a open circuit voltage estimating method, and a degradation level calculating method and device in which the charging state and the open circuit voltage of the battery can be more correctly estimated by considering an inactive degradation. In the battery charging state estimating method and the open circuit voltage estimating method using the degradation level calculating method, the ratio of the total quantity of electricity chargeable and dischargeable for the battery at any time to the initial quantity of electricity of the undegraded battery can be calculated as a degradation level, and the charging state and the open circuit voltage of the battery at any time can be estimated based on the degradation level.

According to the technologies above, the battery degraded state and the change of the capacity of the battery with the degradation can be estimated, but the technologies do not refer to the control performed by changing the charging method based on the change.
[Patent Document 1] Japanese Laid-open Patent Publication No. 2007-166789
[Patent Document 2] Japanese Laid-open Patent Publication No. 2001-257008
[Patent Document 3] Japanese Laid-open Patent Publication No. 2004-354050

### SUMMARY

The present invention has been developed to solve the above-mentioned problems, and aims at providing a system and a method for performing a charging operation using the optimum current profile even when a capacity profile is changed by the degradation of a battery.

A system according to an aspect of the present invention includes a SOC acquisition unit for acquiring a SOC, and estimating a capacity profile from the acquired SOC; an estimation unit for calculating a current profile from the estimated capacity profile; and a charging unit for performing a charging operation based on the calculated current profile.

In the system according to the present invention above, the capacity profile can be estimated using a current, a voltage, and a temperature of a battery being charged and acquired by the SOC acquisition unit.

The system according to the present invention above can further include an update unit for replacing the stored current profile with the current profile calculated by the estimation unit.

In this case, the system can further include a storage unit for storing the current profile calculated by the estimation unit, and the charging unit can read the current profile from the storage unit.

A method according to an aspect of the present invention includes a step of acquiring a SOC, a step of estimating a capacity profile from the acquired SOC; a step of calculating a current profile from the estimated capacity profile; and a step of performing a charging operation based on the calculated current profile.

The method according to the present invention above can further include a step of estimating the capacity profile using a current, a voltage, and a temperature of a battery being charged.

The method according to the present invention above can further include a step of updating the stored current profile with the calculated current profile.

In this case, the method can further include a step of storing the calculated current profile, and a step of reading the stored current profile.

Additionally, a program for directing a computer to use the method according to the above-mentioned present invention can solve the problems above because it has the same operation and effect as the method according to the present invention above by directing the computer to perform the program.

### BRIEF DESCRIPTION OF DRAWINGS

FIG. 1 is a block diagram of charging a battery according to an embodiment of the present invention;
FIG. 2 illustrates a change of a capacity profile by degradation and a current profile calculated depending on the change;
FIG. 3 is a block diagram of the configuration of a SOC acquisition unit 1 and an estimation unit 2; and
FIG. 4 is a flowchart of calculating a current profile from a capacity profile and storing the current profile according to an embodiment of the present invention.

### DESCRIPTION OF EMBODIMENTS

The embodiments of the present invention are described below with reference to the attached drawings. The matters necessary in embodying the present invention, but other than the items specifically described in the present specification can be understood by those skilled in the art based on the prior art in the present technical field. The present invention can be embodied based on the contents disclosed in the present specification and the technological common knowledge in the present technological field.

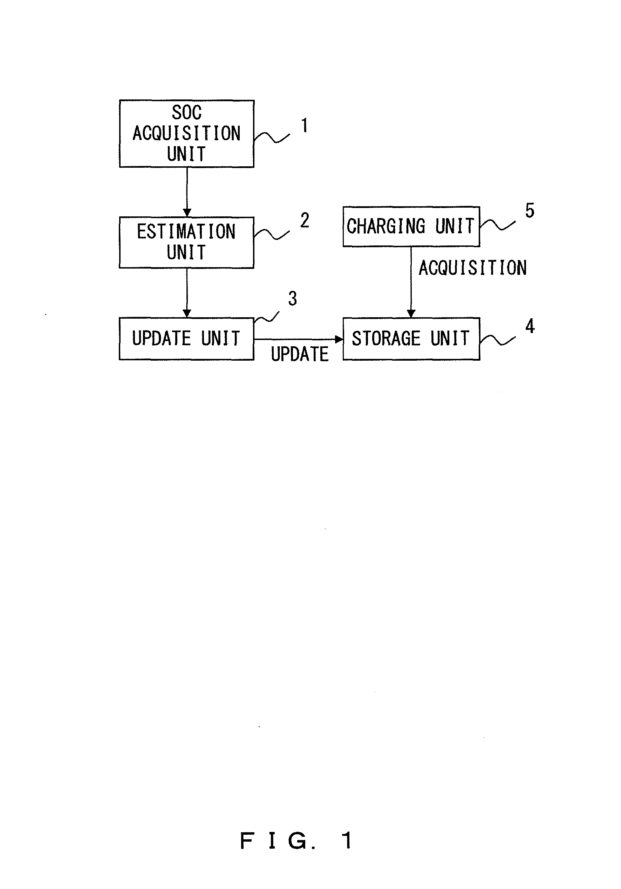

FIG. 1 is a block diagram of charging a battery according to an embodiment of the present invention.

The SOC acquisition unit 1 acquires the SOC of a battery. Then, it estimates a capacity profile from the acquired SOC, and transmits the estimated capacity profile to the estimation unit 2. The SOC refers to the state of charge, and is used as an index of the charging state of a battery.

The estimation unit 2 calculates the current profile for realizing the capacity profile estimated by the SOC acquisition unit 1.

An update unit 3 replaces the existing stored current profile with the current profile calculated by the estimation unit 2.

A storage unit 4 stores the current profile calculated by the estimation unit 2 and updated by the update unit 3.

A charging unit 5 reads the current profile stored in the storage unit 4, and performs the charging operation based on the current profile. The method of controlling a charging current value by a computer according to the current profile calculated by the estimation unit 2 is used according to the prior art.

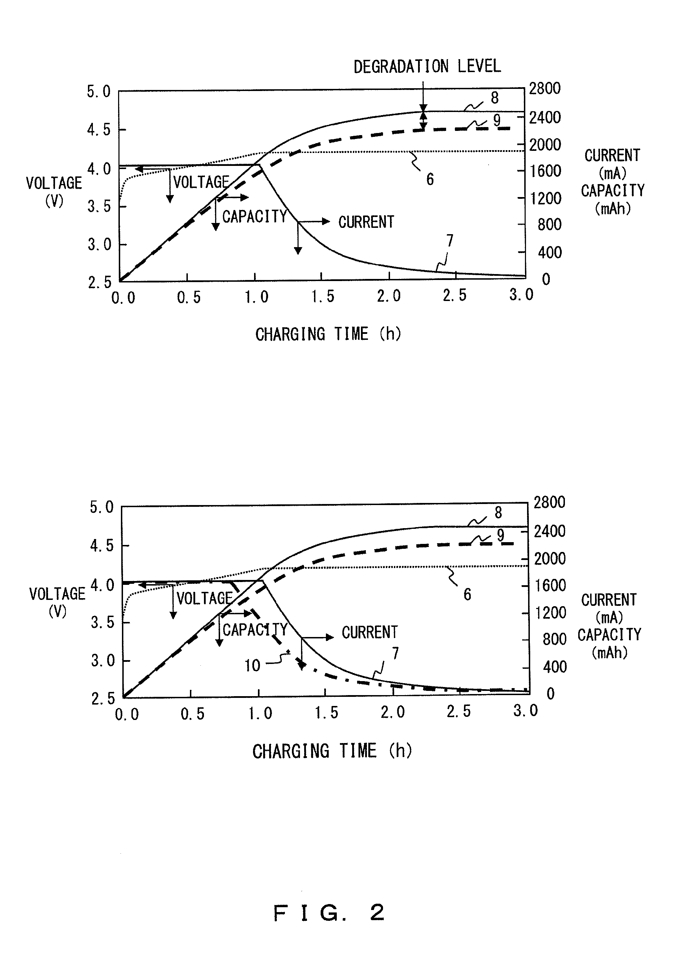

Next, FIG. 2 illustrates a change of a capacity profile by degradation and a current profile calculated depending on the change. The upper part of FIG. 2 illustrates the change of a capacity profile by degradation, and the lower part of FIG. 2 illustrates the current profile calculated from the estimation of the degraded capacity profile. The horizontal axis indicates the charging time (h), the left vertical axis indicates the voltage (V), and the right vertical axis indicates the current (mA) and the capacity (mAh).

In the upper part of FIG. 2, a dotted line 6 indicates a voltage profile, a solid line 7 indicates a current profile when charging is performed before degradation, a solid line 8 indicates a capacity profile before degradation, and a broken line 9 indicates a capacity profile after estimated degradation. In the lower part of FIG. 2, the dotted line 6, the solid line 7, the solid line 8, and the broken line 9 are the same as those in the upper part above, and a dot-and-dash line 10 indicates a current profile calculated from the capacity profile after the estimated degradation.

First, in the upper part of FIG. 2, as indicated by the solid line 7, the charging operation is started by a constant current. As a result, the voltage increases upon start of the charging operation as indicated by the dotted line 6. In FIG. 2, the charging operation reaches a state called "full charge" when the voltage becomes constant at a time point, for example, in about 1.0 h in FIG. 2. When the full charge state is reached, the current profile is used for a gradual current decrease.

Since the electric charge which can be accumulated with the degradation of a battery decreases, it is considered that the capacity profile changes as indicated by the solid lines 8 and the broken line 9, but the change of the capacity is unknown, and it is hard to directly measure the change. Therefore, when the charging operation is performed using the current profile indicated by the solid line 7, the current, voltage, and temperature of the battery are measured, and the SOC is acquired using the prior art for obtaining the SOC.

For example, the following method is used. The terminal voltage, the current, and the cell temperature are read and the open voltage is estimated based on the terminal voltage. In addition, the sampling time is calculated based on the current change rate, and the current average value is calculated using the sampling time. Then, based on the current average value and the cell temperature, a specified current capacity table is referenced, thereby calculating the full charge capacity. Then, the remaining current capacity can be calculated based on the full charge capacity, the open voltage, the upper limit voltage, and the lower limit voltage. For example, the SOC can be acquired using the method above.

The SOC is an index indicating the charging state of a battery, and indicates how much the battery is charged relative to the original battery capacity. Therefore, it is considered that the capacity profile after the degradation as indicated by the broken line 9 can be estimated based on the value of the SOC. In this example, as indicated by the arrow illustrated in the upper part of FIG. 2, the degradation level of the constant value, that is, the capacity value in the full charge state, is defined as the degradation level of a battery.

As indicated by the broken line 9, if the charging operation is performed using the current profile before the degradation indicated by the solid line 7 in the state in which the battery is degraded and the capacity profile is changed, then the overcharge state occurs, and the degradation of the battery is sped up. Accordingly, the charging current value is changed with the change of the capacity value. That is, it is important to use the optimum current profile.

In the lower part of FIG. 2, the estimated capacity profile indicated by the broken line 9 is time-differentiated, thereby calculating the optimum current profile after the degradation as indicated by the dot-and-dash line 10. Using the current profile, the control of decreasing the charging current can be performed at an earlier stage with a change of the capacity profile.

Since the upper limit of the voltage is first set with a margin of about 20%, it is assumed that the voltage profile indicated by the dotted line 6 has not been changed in the state in which the battery is degraded.

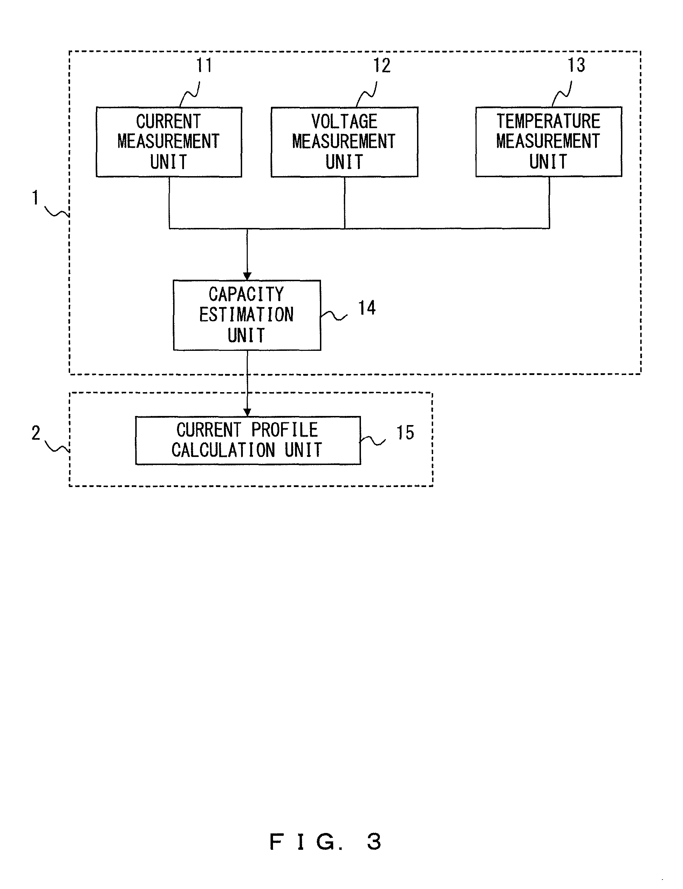

FIG. 3 is a block diagram of the configuration of the SOC acquisition unit 1 and the estimation unit 2.

The SOC acquisition unit 1 includes a current measurement unit 11, a voltage measurement unit 12, a temperature measurement unit 13, and a capacity estimation unit 14. Furthermore, the estimation unit 2 includes a current profile calculation unit 15.

The current measurement unit 11 measures the current passing through the battery being charged. The voltage measurement unit 12 measures the battery voltage being charged. The temperature measurement unit 13 measures the temperature of the battery being charged. The SOC acquisition unit 1 acquires the SOC using the prior art for obtaining the SOC from the accumulated value of the current, the voltage, and the temperature measured by the three measurement units above. The capacity estimation unit 14 estimates the capacity profile based on the acquired SOC, and transmits the estimation result to the current profile calculation unit 15.

The current profile calculation unit 15 time-differentiates the capacity profile estimated by the capacity estimation unit 14, thereby calculating the current profile depending on the capacity profile.

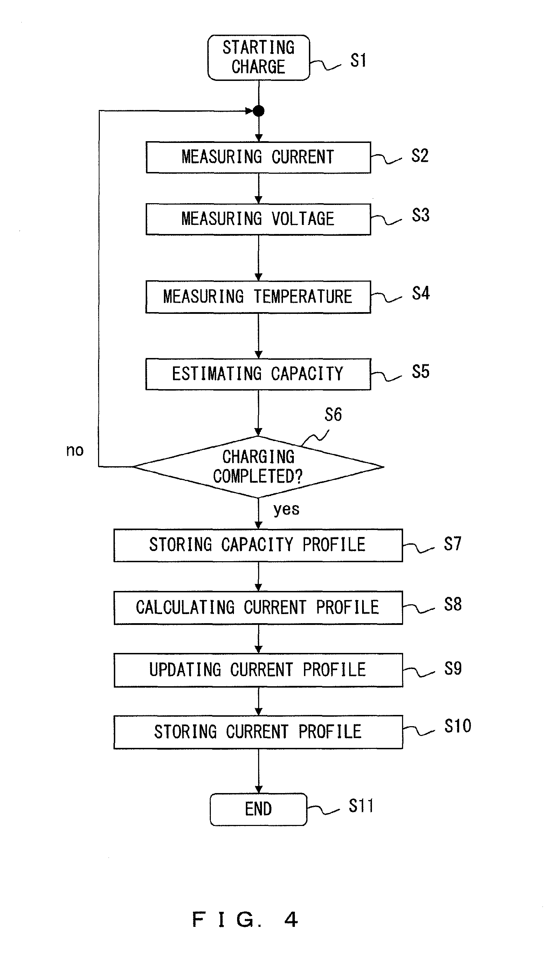

FIG. 4 is a flowchart of calculating a current profile from a capacity profile and storing the current profile according to an embodiment of the present invention.

First, the control is started when the charging operation is started (step S1). Then, the current measurement unit 11 in the SOC acquisition unit 1 measures the current passing in the battery being charged (step S2), the voltage measurement unit 12 measures the voltage of the battery being charged (step S3), and the temperature measurement unit 13 measures the temperature of the battery being charged, thereby obtaining the SOC (step S4) . Then, the capacity estimation unit 14 estimates the capacity profile based on the SOC acquired in step S4 (step S5) .

Afterwards, the SOC acquisition unit 1 determines whether or not the charging operation has been completed (step S6), passes control to step S7 if the charging operation has been completed, and returns control to step S2 if the charging operation has not been completed. In step S7, the capacity profile estimated by the capacity estimation unit 14 is stored in the storage unit 4.

Then, by time-differentiating the capacity profile estimated by the capacity estimation unit 14, the current profile calculation unit 15 in the estimation unit 2 calculates the current profile depending on the capacity profile (step S8) . Then, the update unit 3 updates the existing stored current profile by replacing it with the current profile calculated by the current profile calculation unit 15 (step S9) . Furthermore, the storage unit 4 stores the current profile calculated by the current profile calculation unit 15 in the estimation unit 2 and updated by the update unit 3 (step S10) . Then, control is passed to step S11, thereby terminating the control.

According to the present invention, although a capacity profile is changed by the degradation of a battery, the battery can be charged using the optimum current profile, thereby preventing overcharge and making the most of the life of the battery.

Furthermore, by managing the information about the capacity profile of a battery as a history and the ID of a battery, battery authentication can be performed during the charging operation.

A SOC acquisition unit (1) acquires a SOC of a battery.. Then, it estimates a capacity profile from the acquired SOC, and transmits the estimated capacity profile to an estimation unit (2). The estimation unit (2) calculates a current profile for realizing the capacity profile estimated by the SOC acquisition unit (1) . An update unit (3) replaces the existing stored current profile with the current profile calculated by the estimation unit (2). A storage unit (4) stores a current profile calculated by the estimation unit (2) and updated by the update unit (3). A charging unit (5) reads the current profile stored in the storage unit (4), and performs a charging operation based on the current profile.

## Claims

1. A system, comprising:
an SOC acquisition unit (1) that acquires a SOC, and estimates a capacity profile from the acquired SOC;
an estimation unit (2) that calculates a current profile from the estimated capacity profile; and
a charging unit (5) that performs a charging operation based on the calculated current profile.

2. The system according to claim 1, wherein
the capacity profile is estimated using a current, a voltage, and a temperature of a battery being charged and acquired by the SOC acquisition unit (1).

3. The system according to claim 1, further comprising
an update unit (3) that replaces the stored current profile with the current profile calculated by the estimation unit (2).

4. The system according to claim 2, further comprising
an update unit (3) that replaces the stored current profile with the current profile calculated by the estimation unit (2).

5. The system according to any of claims 1 through 4, further comprising
a storage unit (4) that stores the current profile calculated by the estimation unit (2), wherein
the charging unit (5) reads the current profile from the storage unit.

6. A method comprising:
a step of acquiring a SOC;
a step of estimating a capacity profile from the acquired SOC;
a step of calculating a current profile from the estimated capacity profile; and
a step of performing a charging operation based on the calculated current profile.

7. The method according to claim 6, further comprising
a step of estimating the capacity profile using a current, a voltage, and a temperature of a battery being charged.

8. The method according to claim 6, further comprising
a step of updating the stored profile with the calculated current profile.

9. The method according to claim 7, further comprising
a step of updating the stored profile with the calculated current profile.

10. The method according to any of claims 6 through 9, further comprising:
a step of storing the calculated current profile; and
a step of reading the stored current profile.
